# EUROPEAN PATENT APPLICATION

(11) **EP 4 653 940 A1**
(43) Date of publication of application: **26.11.2025**
(21) Application number: 24793090.2
(22) Date of filing: 29.01.2024
(51) Int. Cl.: G02F 1/1333, G02F 1/1339, H10K 59/80, H01L 27/15

(54) **DISPLAY DEVICE INCLUDING INNER MOLD AND MANUFACTURING METHOD OF SAME**

(30) Priority: 19.04.2023 KR 20230051454; 12.05.2023 KR 20230061530
(71) Applicant: Samsung Electronics Co., Ltd., Suwon-si, Gyeonggi-do 16677 (KR)
(72) Inventor: LEE, Dokyun, Suwon-si Gyeonggi-do 16677 (KR); RYU, Jeongyi, Suwon-si Gyeonggi-do 16677 (KR); SEO, Sungkyo, Suwon-si Gyeonggi-do 16677 (KR); LIM, Gun, Suwon-si Gyeonggi-do 16677 (KR); CHO, Hyunje, Suwon-si Gyeonggi-do 16677 (KR)
(74) Representative: Gulde & Partner
(86) International application number: PCT/KR2024/095063
(87) International publication number: WO 2024/219906

(57) **Abstract**

A display device according to one embodiment may comprise: a housing; a display panel provided inside the housing; a cover layer coupled to an upper side of the display panel and including a protruding area that protrudes beyond a side surface of the display panel; an inner mold disposed on a lower side of the protruding area of the cover layer so as to be spaced a predetermined distance from the side surface of the display panel; and a sealing member provided in the space between the inner mold and the display panel. In one embodiment, the sealing member may contact each of the display panel, the cover layer, and the inner mold.

## Description

### Technical Field

Various embodiments disclosed herein relate to a display device including an inner mold and a manufacturing method of the same.

### Background Art

A display device may be a device that includes a display module and outputs visual information to a user. Display devices have been developed to be available in various forms, and for example, portable display devices such as portable smartphones, laptops, and tablet personal computers (PCs) as well as home or industrial output devices such as televisions (TVs) and monitors have been commercialized.

A display device may express various colors through pixel or sub-pixel unit operations through a display module. In addition to research for improving the performance and durability of display devices, there has been a technical demand for reducing the width of the bezel of display devices, and research has continued to improve manufacturing efficiency or yield of display devices.

However, the above description should not be construed as being considered as a prior art to the description of the present disclosure, and should be construed only as a related art related to the invention described herein.

### DISCLOSURE OF THE INVENTION

### Technical Goals

According to an embodiment of the present disclosure, a display device and a manufacturing method thereof that reduce a width of a bezel of the display device, improve durability, or improve manufacturing efficiency may be provided.

However, technical aspects to be achieved through various embodiments disclosed in the present disclosure are not limited to the aforementioned aspects, and other technical aspects not mentioned will be clearly understood by one of ordinary skill in the art to which the invention described herein pertains from the description below.

### Technical Solutions

A display device according to an embodiment may include a housing, a display panel provided inside the housing, a cover layer coupled to an upper side of the display panel and including a protruding area that protrudes beyond a side surface of the display panel, an inner mold disposed on a lower side of the protruding area of the cover layer so as to be spaced a predetermined distance from the side surface of the display panel, and a sealing member provided in a spacing S between the inner mold and the display panel. In an embodiment, the sealing member may contact each of the display panel, the cover layer, and the inner mold.

Alternatively, a manufacturing method of a display device according to an embodiment may include coupling, a cover layer including a protruding area that protrudes beyond a side surface of a display panel, to an upper side of the display panel, coupling an inner mold to a lower side of the protruding area so as to be spaced a predetermined distance from the side surface of the display panel, filling a sealing member into a spacing S between the inner mold and the display panel, and coupling the inner mold to the housing such that the display panel is disposed inside the housing. In an embodiment, the filling of the sealing member may include filling the sealing member such that the sealing member contacts each of the display panel, the cover layer, and the inner mold.

Alternatively, in a disassembling method of a display device by separating a display module from a housing that accommodates the display module according to an embodiment, the display module may include a display panel, a cover layer coupled to an upper side of the display panel and including a protruding area that protrudes beyond a side surface of the display panel, an inner mold disposed on a lower side of the protruding area of the cover layer so as to be spaced a predetermined distance from the side surface of the display panel, and a sealing member provided in a spacing S between the inner mold and the display panel and contacting each of the display panel, the cover layer, and the inner mold. In an embodiment, the disassembling method may include heating a first adhesive member made of a thermoplastic material and provided between the inner mold and the housing, and separating the display module from the housing. In an embodiment, the heating of the first adhesive member may include, in a lower direction of the housing, heating an external area of the housing opposite a position where the inner mold is disposed.

### BRIEF DESCRIPTION OF DRAWINGS

FIG. 1 is a block diagram illustrating an electronic device in a network environment according to various embodiments of the disclosure;
FIG. 2 is a block diagram of the display module according to various embodiment of the disclosure;
FIG. 3 is a perspective view of a display device according to an embodiment of the disclosure;
FIG. 4 is an exploded perspective view of the display device according to an embodiment of the disclosure;
FIG. 5A is a schematic view illustrating a cross-section of the display device according to an embodiment of the disclosure;
FIG. 5B is a schematic view illustrating a cross-section of the display device according to an embodiment of the disclosure;
FIG. 6A is a schematic view illustrating a cross-section of the display device according to an embodiment of the disclosure;
FIG. 6B is a schematic view illustrating a cross-section of the display device according to an embodiment of the disclosure;
FIG. 7 is a flowchart of a manufacturing method of the display device according to an embodiment of the disclosure;
FIG. 8A is a schematic view illustrating a cross-section of a state of the manufacturing method of the display device according to an embodiment of the disclosure;
FIG. 8B is a schematic view illustrating a cross-section of a state of the manufacturing method of the display device according to an embodiment of the disclosure;
FIG. 8C is a schematic view illustrating a cross-section of a state of the manufacturing method of the display device according to an embodiment of the disclosure;
FIG. 8D is a schematic view illustrating a cross-section of a state of the manufacturing method of the display device according to an embodiment of the disclosure;
FIG. 9 is a flowchart of a disassembling method of the display device according to an embodiment of the disclosure; and
FIG. 10 is a schematic view illustrating a cross-section of a state of the disassembling method of the display device according to an embodiment of the disclosure.

### BEST MODE FOR CARRYING OUT THE INVENTION

Hereinafter, embodiments will be described in detail with reference to the accompanying drawings. When describing the embodiments with reference to the accompanying drawings, like reference numerals refer to like elements and a repeated description related thereto will be omitted.

It should be appreciated that various embodiments of the disclosure and the terms used therein are not intended to limit the technical features set forth herein to particular embodiments and include various changes, equivalents, or replacements for a corresponding embodiment. With regard to the description of the drawings, similar reference numerals may be used to refer to similar or related components. It is to be understood that a singular form of a noun corresponding to an item may include one or more of the things, unless the relevant context clearly indicates otherwise. As used herein, "A or B," "at least one of A and B," "at least one of A or B," "A, B or C," "at least one of A, B and C," and "at least one of A, B, or C," each of which may include any one of the items listed together in the corresponding one of the phrases, or all possible combinations thereof. Terms such as "first," "second," or "first" or "second" may simply be used to distinguish the component from other components in question, and do not limit the components in other aspects (e.g., importance or order). It is to be understood that if an element (e.g., a first element) is referred to, with or without the term "operatively" or "communicatively," as "coupled with," "coupled to," "connected with," or "connected to" another element (e.g., a second element), it means that the element may be coupled with the other element directly (e.g., by wire), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry." A module may be a single integral component, or a minimum unit or part thereof, adapted to perform one or more functions. For example, according to an embodiment, the module may be implemented in a form of an application-specific integrated circuit (ASIC).

Various embodiments may be implemented as software (e.g., a program 140) including one or more instructions that are stored in a storage medium (e.g., internal memory 136 or external memory 138) that is readable by a machine (e.g., an electronic device). For example, a processor of the machine (e.g., the electronic device) may invoke at least one of the one or more instructions stored in the storage medium, and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to embodiments, each component (e.g., a module or a program) of the above-described components may include a single entity or multiple entities, and some of the multiple entities may be separately disposed in different components. According to various embodiments, one or more of the above-described components or operations may be omitted, or one or more other components or operations may be added. Alternatively or additionally, a plurality of components (e.g., modules or programs) may be integrated into a single component. In such a case, according to embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

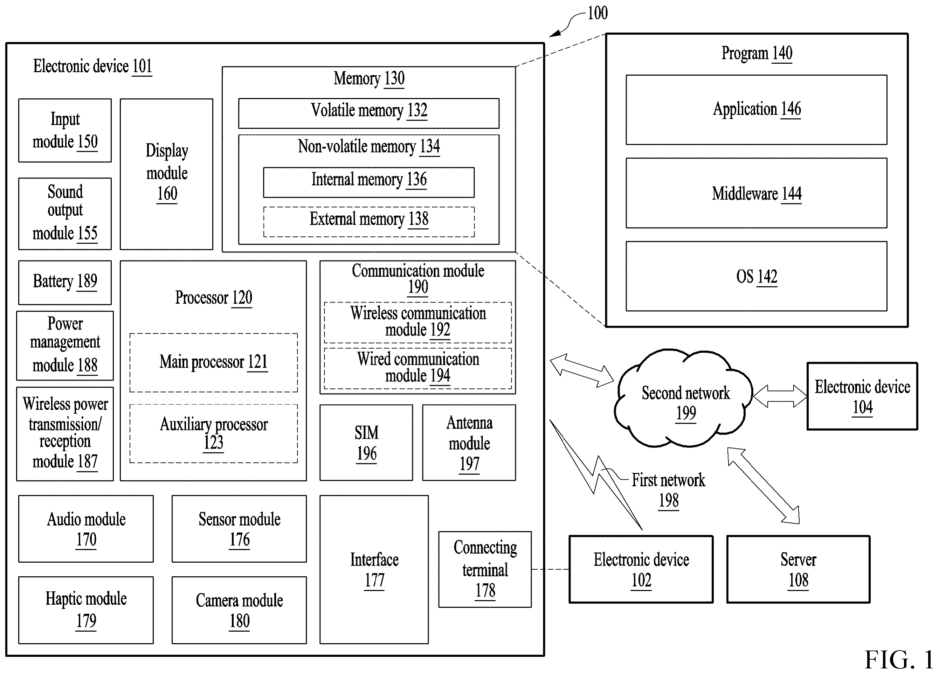

FIG. 1 is a block diagram illustrating an electronic device 101 in a network environment 100 according to various embodiments of the disclosure. Referring to FIG. 1, the electronic device 101 in the network environment 100 may communicate with an electronic device 102 via a first network 198 (e.g., a short-range wireless communication network), or communicate with at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one (e.g., the connecting terminal 178) of the above components may be omitted from the electronic device 101, or one or more other components may be added to the electronic device 101. In some embodiments, some (e.g., the sensor module 176, the camera module 180, or the antenna module 197) of the components may be integrated as a single component (e.g., the display module 160).

The processor 120 may execute, for example, software (e.g., the program 140) to control at least one other component (e.g., a hardware or software component) of the electronic device 101 connected to the processor 120, and may perform various data processing or computation. According to an embodiment, as at least a portion of data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)) or an auxiliary processor 123 (e.g., a graphics processing unit (GPU), a neural processing unit (NPU), an image signal processor (ISP), a sensor hub processor, or a communication processor (CP)) that is operable independently of, or in conjunction with the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented separately from the main processor 121 or as a part of the main processor 121.

The auxiliary processor 123 may control at least some of functions or states related to at least one (e.g., the display module 160, the sensor module 176, or the communication module 190) of the components of the electronic device 101, instead of the main processor 121 while the main processor 121 is in an inactive (e.g., sleep) state or along with the main processor 121 while the main processor 121 is an active state (e.g., executing an application). According to an embodiment, the auxiliary processor 123 (e.g., an ISP or a CP) may be implemented as a portion of another component (e.g., the camera module 180 or the communication module 190) that is functionally related to the auxiliary processor 123. According to an embodiment, the auxiliary processor 123 (e.g., an NPU) may include a hardware structure specified for artificial intelligence (AI) model processing. The AI model may be generated by machine learning. Such learning may be performed, for example, by the electronic device 101 in which an artificial intelligence model is executed, or via a separate server (e.g., the server 108). Learning algorithms may include, but are not limited to, for example, supervised learning, unsupervised learning, semi-supervised learning, or reinforcement learning. The AI model may include a plurality of artificial neural network layers. An artificial neural network may include, for example, a deep neural network (DNN), a convolutional neural network (CNN), a recurrent neural network (RNN), a restricted Boltzmann machine (RBM), a deep belief network (DBN), a bidirectional recurrent deep neural network (BRDNN), a deep Q-network, or a combination of two or more thereof, but is not limited thereto. The AI model may additionally or alternatively include a software structure other than the hardware structure.

The memory 130 may store various data used by at least one component (e.g., the processor 120 or the sensor module 176) of the electronic device 101. The various pieces of data may include, for example, software (e.g., the program 140) and input data or output data for a command related thereto. The memory 130 may include the volatile memory 132 or the non-volatile memory 134.

The program 140 may be stored as software in the memory 130 and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output a sound signal to the outside of the electronic device 101. The sound output module 155 may include, for example, a speaker or a receiver. The speaker may be used for general purposes, such as playing multimedia or playing a record. The receiver may be used to receive an incoming call. According to an embodiment, the receiver may be implemented separately from the speaker or as a portion of the speaker.

The display module 160 may visually provide information to the outside (e.g., a user) of the electronic device 101. The display module 160 may include, for example, a display, a hologram device, or a projector and control circuitry to control a corresponding one of the display, the hologram device, and the projector. According to an embodiment, the display module 160 may include a touch sensor adapted to sense a touch, or a pressure sensor adapted to measure an intensity of a force incurred by the touch.

The audio module 170 may convert a sound into an electric signal and vice versa. According to an embodiment, the audio module 170 may obtain the sound via the input module 150 or output the sound via the sound output module 155 or an external electronic device (e.g., an electronic device 102 such as a speaker or a headphone) directly or wirelessly connected to the electronic device 101.

The sensor module 176 may detect an operational state (e.g., power or temperature) of the electronic device 101 or an environmental state (e.g., a state of a user) external to the electronic device 101, and generate an electric signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., by wire) or wirelessly. According to an embodiment, the interface 177 may include, for example, a high-definition multimedia interface (HDMI), a universal serial bus (USB) interface, a secure digital SD) card interface, or an audio interface.

The connecting terminal 178 may include a connector via which the electronic device 101 may be physically connected to an external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electric signal into a mechanical stimulus (e.g., a vibration or a movement) or an electrical stimulus which may be recognized by a user via his or her tactile sensation or kinesthetic sensation. According to an embodiment, the haptic module 179 may include, for example, a motor, a piezoelectric element, or an electric stimulator.

The camera module 180 may capture a still image and moving images. According to an embodiment, the camera module 180 may include one or more lenses, image sensors, ISPs, or flashes.

The power management module 188 may manage power supplied to the electronic device 101. According to an embodiment, the power management module 188 may be implemented as, for example, at least a portion of a power management integrated circuit (PMIC). The wireless power transmission/reception module 187 may be configured to transmit and receive power wirelessly.

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more CPs that are operable independently of the processor 120 (e.g., an AP) and that support a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication (PLC) module). A corresponding one of these communication modules may communicate with the external electronic device 104 via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a fifth generation (5G) network, a next-generation communication network, the Internet, or a computer network (e.g., a LAN or a wide area network (WAN))). These various types of communication modules may be implemented as a single component (e.g., a single chip), or may be implemented as multiple components (e.g., multiple chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network after a fourth generation (4G) network, and a next-generation communication technology, e.g., a new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., a millimeter wave (mmWave) band) to achieve, e.g., a high data transmission rate. The wireless communication module 192 may support various technologies for securing performance on a high-frequency band, such as, e.g., beamforming, massive multipleinput and multiple-output (MIMO), full dimensional MIMO (FD-MIMO), an array antenna, analog beam-forming, or a large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., an external electronic device). According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in a communication network, such as the first network 198 or the second network 199, may be selected by, for example, the communication module 190 from the plurality of antennas. The signal or power may be transmitted or received between the communication module 190 and the external electronic device via the at least one selected antenna. According to an embodiment, another component (e.g., a radio frequency integrated circuit (RFIC)) other than the radiating element may be additionally formed as a part of the antenna module 197.

According to an embodiment, the antenna module 197 may form a mmWave antenna module. According to an embodiment, the mmWave antenna module may include a PCB, an RFIC disposed on a first surface (e.g., a bottom surface) of the PCB or adjacent to the first surface and capable of supporting a designated a high-frequency band (e.g., the mmWave band), and a plurality of antennas (e.g., array antennas) disposed on a second surface (e.g., a top or a side surface) of the PCB, or adjacent to the second surface and capable of transmitting or receiving signals in the designated high-frequency band.

At least some of the above-described components may be coupled mutually and communicate signals (e.g., commands or data) therebetween via an interperipheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 and 104 may be a device of the same type as or a different type from the electronic device 101. According to an embodiment, all or some of operations to be executed at the electronic device 101 may be executed at one or more of external electronic devices (e.g., the external devices 102 and 104, and the server 108). For example, if the electronic device 101 needs to perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and may transfer an outcome of the performing to the electronic device 101. The electronic device 101 may provide the outcome, with or without further processing of the outcome, as at least part of a reply to the request. To this end, cloud computing, distributed computing, mobile edge computing (MEC), or client-server computing technology may be used, for example. The electronic device 101 may provide ultra low-latency services using, e.g., distributed computing or MEC. In an embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to embodiments may be one of various types of electronic devices. The electronic device may include, for example, a portable communication device (e.g., a smartphone), a computer device, a portable multimedia device, a portable medical device, a camera, a wearable device, or a home appliance device. According to an embodiment of the disclosure, the electronic device is not limited to those described above.

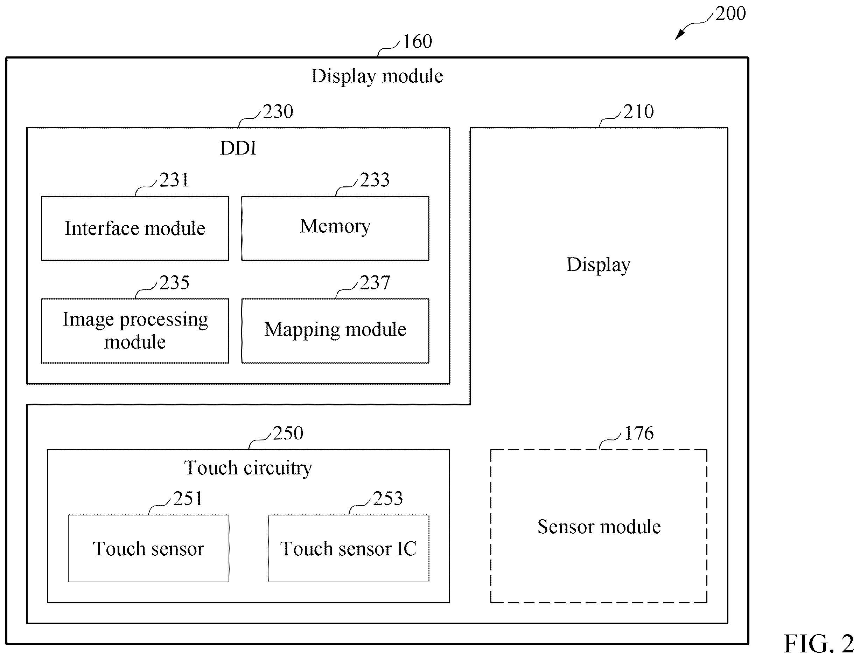

FIG. 2 is a block diagram of the display module according to various embodiment of the disclosure.

Referring to FIG. 2, the display module 160 may include a display 210 and a display driver integrated circuit (IC) (DDI) 230 to control the display 210. The DDI 230 may include an interface module 231, memory 233 (e.g., buffer memory), an image processing module 235, or a mapping module 237. The DDI 230 may receive image information that contains image data or an image control signal corresponding to a command to control the image data from another component of the electronic device 101 via the interface module 231. For example, according to an embodiment, the image information may be received from the processor 120 (e.g., the main processor 121 (e.g., an AP)) or the auxiliary processor 123 (e.g., a GPU) operated independently from the function of the main processor 121. The DDI 230 may communicate with touch circuitry 250 or the sensor module 176 via the interface module 231. The DDI 230 may also store at least part of the received image information in the memory 233, for example, on a frame-by-frame basis. The image processing module 235 may perform preprocessing or post-processing (e.g., adjustment of a resolution, brightness, or size) on at least a portion of the image data based on characteristics of the image data or characteristics of the display 210. The mapping module 237 may generate a voltage value or a current value corresponding to the image data preprocessed or post-processed by the image processing module 235. According to an embodiment, a voltage value or a current value may be generated, for example, based on at least some of attributes of pixels of the display 210 (e.g., arrangement of pixels (red, green, and blue (RGB) stripe or pentile structure) or a size of each sub-pixel). At least some of the pixels of the display 210 may be driven based on, for example, at least a portion of the voltage value or the current value to display visual information (e.g., a text, image, or icon) corresponding to the image data through the display 210.

According to an embodiment, the display module 160 may further include the touch circuitry 250. The touch circuitry 250 may include a touch sensor 251 and a touch sensor IC 253 to control the touch sensor 251. The touch sensor IC 253 may control the touch sensor 251, for example, to sense a touch input or a hovering input with respect to a predetermined position on the display 210. For example, the touch sensor IC 253 may sense the touch input or the hovering input by measuring a change in a signal (e.g., a voltage, a quantity of light, a resistance, or an amount of charge) corresponding to the predetermined position on the display 210. The touch sensor IC 253 may provide information (e.g., a position, area, pressure, or time) about the sensed touch input or hovering input to the processor 120. According to an embodiment, at least part (e.g., the touch sensor IC 253) of the touch circuitry 250 may be included as part of the display 210 or the DDI 230, or as part of another component (e.g., the auxiliary processor 123) disposed outside the display module 160.

According to an embodiment, the display module 160 may further include at least one sensor (e.g., a fingerprint sensor, an iris sensor, a pressure sensor, or an illuminance sensor) of the sensor module 176 or a control circuit for the at least one sensor. In this case, the at least one sensor or the control circuit for the at least one sensor may be embedded in a portion of the display module 160 (e.g., the display 210 or the DDI 230) or a portion of the touch circuitry 250. For example, when the sensor module 176 embedded in the display module 160 includes a biometric sensor (e.g., a fingerprint sensor), the biometric sensor may obtain biometric information (e.g., a fingerprint image) associated with a touch input through a partial area of the display 210. As another example, when the sensor module 176 embedded in the display module 160 includes a pressure sensor, the pressure sensor may obtain pressure information associated with a touch input through a partial or entire area of the display 210. According to an embodiment, the touch sensor 251 or the sensor module 176 may be disposed between pixels in a pixel layer of the display 210, or over or under the pixel layer.

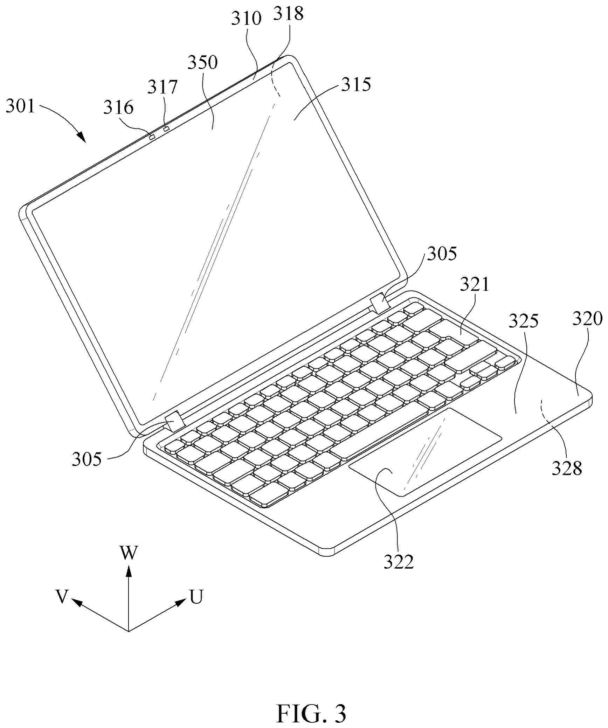

FIG. 3 is a perspective view of a display device according to an embodiment of the disclosure.

Referring to FIG. 3, the display device 301 (e.g., the electronic device 101 of FIG. 1) according to various embodiments may include at least one of a first housing 310, a second housing 320, and a display module 350 (e.g., the display module 160 of FIG. 1 or 2).

In an embodiment, the display device 301 may be configured as a single unit and may be installed and applied in an electronic product or field, such as a wearable device, a portable device, a handheld device, or a mobile device or wireless communication device requiring a display.

In an embodiment, the display device 301 may be an electronic device, a wireless communication device, a smartphone, a laptop PC, or a tablet PC. In FIG. 3, for ease of description, a laptop PC is shown as an example of the display device 301, but the actual implementation is not limited thereto and various types of display devices 301 may be implemented.

For example, the display device 301 may be implemented as a TV, or may be applied without limitation to any device having a display function, such as a video wall, a large format display (LFD), a digital signage, a digital information display (DID), or a projector display.

The display device 301 according to an embodiment may be implemented with a plurality of display modules in a matrix type, and through a plurality of assembly arrangements, may be applied to various display devices 301 such as a monitor for a personal computer (PC), a high-resolution TV, and signage (or digital signage), and an electronic display.

In an embodiment, the first housing 310 may form an exterior of the display device 301. In an embodiment, the first housing 310 may include a first surface 315 that is a surface in one direction (e.g., -V direction) of the first housing 310 and a second surface 318 opposite the first surface 315. The first surface 315 may be formed in a state in which most areas of the first surface 315 are open so that the display module 350 may be exposed to the outside, and the display module 350 may display a screen in a direction of the first surface 315.

In an embodiment, the second housing 320 may be foldably connected to the first housing 310 by a hinge unit 305. The second housing 320 may include a third surface 328 that is a surface in one direction (e.g., -W direction) of the second housing 320 and a fourth surface 325 opposite to the third surface 328. The second housing 320 may be formed to have a shape corresponding to the first housing 310, for example, such that the fourth surface 325 of the second housing 320 has a size and area corresponding to the first surface 315 of the first housing 310.

In an embodiment, the second housing 320 may include an input device 321 and a touch pad 322 disposed on the fourth surface 325. The input device 321 may be a keyboard, or may be an input device including a touch recognition function and/or a display function.

In an embodiment, the fourth surface 325 of the second housing 320 may be formed such that the input device 321 and the touch pad 322 may be exposed to the outside. The input device 321 and the touch pad 322 may be exposed to the outside through the fourth surface 325 and may be manipulated by a user. Manipulation information of the user input through the input device 321 and touch pad 322 may be input to a processor (e.g., the processor 120 of FIG. 1).

In an embodiment, a connection state of the first housing 310 and the second housing 320 in the display device 301 may be changed by the hinge unit 305 according to a use state of the user. In various embodiments, one hinge unit 305 may be positioned at the center of a connection area between the first housing 310 and the second housing 320, or a plurality of hinge units 305 may be spaced apart from each other in the connection area between the first housing 310 and the second housing 320. The hinge unit 305 may rotatably connect the first housing 310 and the second housing 320.

In an embodiment, the display device 301 may be in an "unfolded state" in which the display module 350, the input device 321, and the touch pad 322 are visually exposed to the outside, and in a "folded state" in which the first surface 315 of the first housing 310 is folded to face the fourth surface 325 of the second housing 320 and the display module 350, the input device 321, and the touch pad 322 are occluded, such that the relative connection state of the first housing 310 and the second housing 320 may be changed.

In an embodiment, the display device 301 may be driven in a plurality of use modes depending on an angle of the first housing 310 and the second housing 320 in the unfolded state, and the display device may be a convertible PC or a 2-in-1 PC.

For example, the display device 301 that is a convertible PC may have the first housing 310 that may rotate substantially 360 degrees relative to the second housing 320. For example, the hinge unit 305 may adjust a rotation angle, which is an angle between the first housing 310 and the second housing 320, from a starting angle where the first surface 315 and the fourth surface 325 face each other, to an ending angle where the second surface 318 and the third surface 328 face each other.

For example, the display device 301 may be driven in a clamshell mode or a laptop mode in which the rotation angle is rotated within a range from the starting angle (e.g., 0 degrees) to a set angle (e.g., 180 degrees), or the display device 301 may be driven in a tablet mode in which the rotation angle is rotated within a range from a set angle to the ending angle (e.g., 360 degrees). The user may transform a single display device into various forms to suit their usage environment, and the usability of the display device 301 may be expanded.

In an embodiment, the first housing 310 and the second housing 320 may be detachable from each other. For example, the first housing 310 and the second housing 320 may be integrally connected to each other so as to be rotatable with respect to each other through the hinge unit 305 connecting them, or may be implemented as devices that may be separated and combined in independent configurations.

In an embodiment, the display module 350 may display visual information (e.g., a text, video, and/or image) to the user. In an embodiment, the display module 350 may be connected to the first housing 310 and may be visually exposed to the outside of the display device 301 through the first surface 315 of the first housing 310. For example, the display module 350 may be seated on a recess formed on the first surface 315 of the first housing 310 and may form most of the first surface 315.

In an embodiment, the display module 350 may include a digitizer panel (not shown) for detecting an input (e.g., a touch input or hovering input) from an input device (e.g., a stylus pen). A digitizer may convert analog coordinates of the input device (e.g., a stylus pen) into digital data and transmit the digital data to a processor (e.g., the processor 120 of FIG. 1). The processor 120 may detect the input (e.g., a touch input or hovering input) through the input device (e.g., a stylus pen) based on the digital data input from the digitizer.

In an embodiment, when the display module 350 is visually exposed through the first surface 315, an operational state of the display module 350 may vary depending on the relative connection state of the second housing 320 to the first housing 310. For example, the display module 350 may display visual information to the user by being visually exposed to the outside in the unfolded state. On the other hand, the display module 350 may be occluded by the fourth surface 325 so as not to be visually exposed to the outside in the folded state.

In an embodiment, the display module 350 may control the on/off of a screen according to the unfolded state or the folded state. For example, the display module 350 may be controlled to turn off the screen in the folded state to prevent or reduce unnecessary power consumption. Additionally, the display module 350 may adjust a screen display direction according to a driving mode of the display device 301.

In an embodiment, the display device 301 may set an area connected to the second housing 320 to be a lower area, and display a screen based on an upper direction (e.g., +W direction) and a lower direction (e.g., -W direction).

For example, in the tablet mode, the display device 301 may detect the user's use environment using a gyro sensor (not shown) of a sensor module (e.g., the sensor module 176 of FIG. 1), and the display module 350 may reset the upper and lower directions based on the detection.

In an embodiment, a camera module 316 (e.g., the camera module 180 of FIG. 1) and a sensor module 317 (e.g., the sensor module 176 of FIG. 1) may be disposed in a space provided by the first housing 310, and at least a portion of areas of the camera module 316 and the sensor module 317 may be visually exposed to the first surface 315 of the first housing 310.

For example, the camera module 316 and the sensor module 317 may be visually exposed to the user together with the display module 350 when the first housing 310 and the second housing 320 are in the unfolded state, and may be occluded inside the display device 301 when the first surface 315 of the first housing 310 and the fourth surface 325 of the second housing 320 are in the folded state to face each other.

In an embodiment, a microphone and a sensor device may be disposed in the space provided by the first housing 310. For example, a dual microphone may be disposed in the space provided by the first housing 310. For example, the sensor device may include a proximity sensor, a time of flight (TOF) sensor, or a Lidar sensor to determine the user's location.

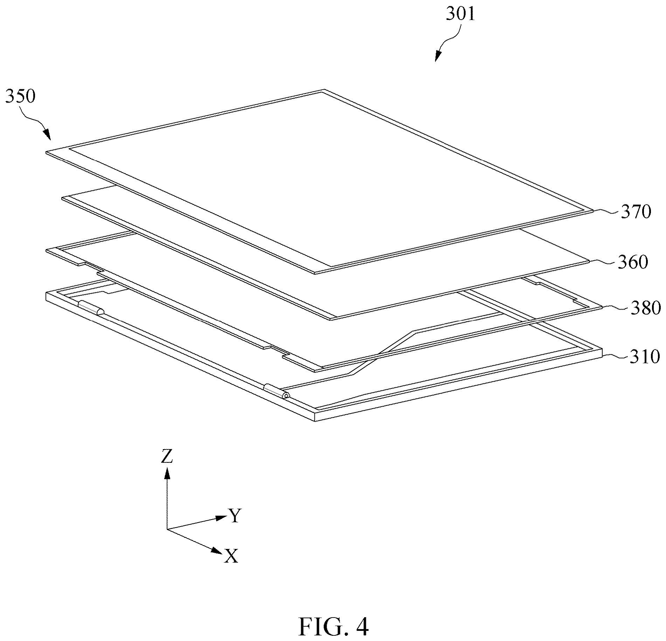

FIG. 4 is an exploded perspective view of the display device according to an embodiment of the disclosure.

Referring to FIG. 4, the display device 301 according to an embodiment may include at least one of a display panel 360 (e.g., the display 210 of FIG. 2), a cover layer 370, and an inner mold 380.

Hereinafter, the description provided above is not repeated, and it is obvious that a portion of the configuration and structure of the display device 301 may be replaced, added, or omitted within a scope easily understandable by one of ordinary skill in the art with reference to the following drawings and descriptions. In addition, at least one component or feature of the embodiments described above may be coupled to the display device 301 unless this is technically and clearly infeasible.

In an embodiment, the display device 301 may display various images or videos. An image may be a concept that includes still images and moving images, and the display device 301 may display images such as broadcast content and multimedia content. Further, the display device 301 may display a user interface (UI) and an icon.

In an embodiment, the display device 301 may include the display module 350 and the housing 310. The housing 310 may support the display module 350.

The "housing 310" described below may be a structure for supporting and/or accommodating at least a portion of the configuration of the display module 350, and may be the first housing 310 of FIG. 3, or may be a housing assembly including the first housing 310 and the second housing 320 of FIG. 3, not limited to the examples in the drawings and descriptions described above.

In an embodiment, the housing 310 may accommodate the display module 350 such that the cover layer 370 of the display module 350 is visually exposed to the outside of the housing 310. The housing 310 may be made of a metal or synthetic material, and may be made of a durable and/or flame-retardant material to protect the display module 350 and other components accommodated therein.

In an embodiment, the display module 350 may include at least one of the display panel 360, the cover layer 370, and the inner mold 380. For example, the display module 350 may include the display panel 360, the cover layer 370, and the inner mold 380. Alternatively, for example, the display module 350 according to an embodiment may include the display panel 360 and the cover layer 370, and the inner mold 380 may be a separate component for supporting or protecting the display module 350.

In an embodiment, the display panel 360 may be a liquid crystal display (LCD), a quantum dot (QD) display, or may be a display of a type such as, but not limited to, an organic light-emitting diode (OLED), a liquid crystal on silicon (LCoS), a digital light processing (DLP), a quantum dot light-emitting diodes (QLED), a micro light-emitting diodes (µLED), or a Mini LED.

In an embodiment, the display panel 360 may be implemented as a touch screen combined with a touch sensor, a flexible display, a rollable display, a 3D display, or a display in which a plurality of display modules 350 are physically connected.

In an embodiment, the display panel 360 may include an IC chip (e.g., the display driver IC 230 of FIG. 2), and the IC chip may display an image based on an image signal received from a processor (e.g., the processor 120 of FIG. 1). The IC chip may display the image by generating driving signals of a plurality of light sources (not shown) of the display panel 360 based on the image signal received from the processor and controlling light emitted from a plurality of pixels included in the display panel 360 based on the driving signals.

The display panel 360 according to an embodiment may also include a driving circuit and a backlight unit that may be implemented in a form such as an a-si TFT, a low temperature poly silicon (LTPS) TFT, or an organic TFT (OTFT).

In an embodiment, the cover layer 370 may be coupled to an upper side (e.g., +Z direction) or an outer surface of the display panel 360. The cover layer 370 may be a transparent material through which light emitted from the display panel 360 may pass. The cover layer 370 may protect the display panel 360 from the outside.

In an embodiment, the inner mold 380 may support the display panel 360 and the cover layer 370. The inner mold 380 may be in a form that surrounds a side surface of the display panel 360 in a side direction (e.g., in an X-Y plane direction).

In an embodiment, the inner mold 380 may be made of an elastic body. The inner mold 380 may absorb external impact and protect the display panel 360 and the cover layer 370. Alternatively, the inner mold 380 of according to an embodiment may guide and support a position where the display panel 360 and the cover layer 370 are disposed.

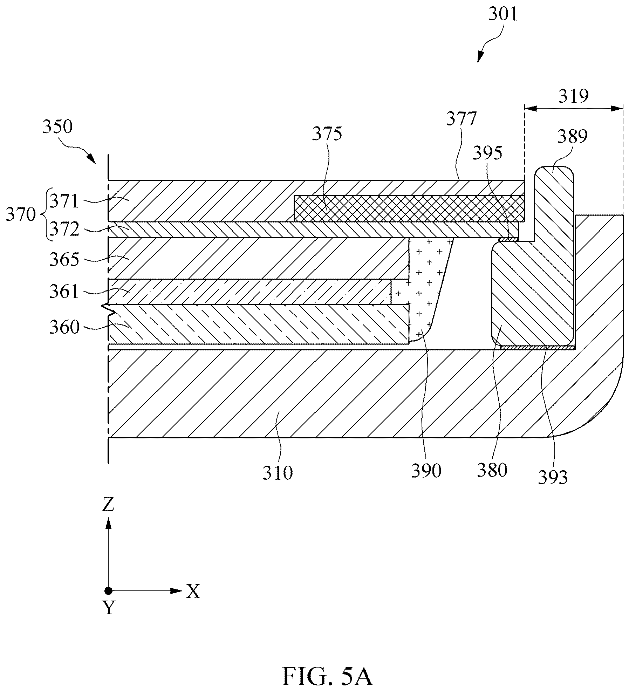

FIG. 5A is a schematic view illustrating a cross-section of the display device according to an embodiment of the disclosure.

Specifically, FIG. 5A is a schematic view of a cross-section viewing an end (e.g., a +X direction end) of the display device 301 according to an embodiment, based on a cross-section parallel to an X-Z plane of FIG. 4.

Referring to FIG. 5A, the display device 301 according to an embodiment may further include at least one of a diffusion layer 361, an adhesive layer 365, a window layer 371, a touch screen panel (TSP) 372, a light blocking member 375, and a sealing member 390.

Hereinafter, the description provided above is not repeated, and it is obvious that a portion of the configuration and structure of the display device 301 may be replaced, added, or omitted within a scope easily understandable by one of ordinary skill in the art with reference to the following drawings and descriptions. In addition, at least one component or feature of the embodiments described above may be coupled to the display device 301 unless this is technically and clearly infeasible.

In an embodiment, the diffusion layer 361 may be formed of a transparent material that may transmit light. The diffusion layer 361 may be formed in a roughly rectangular flat shape having a size corresponding to the display panel 360. In an embodiment, the diffusion layer 361 may be a part of the display panel 360. For example, the display panels 360 and 361 according to an embodiment may together refer to the display panel 360 and the diffusion layer 361 of the drawing.

In an embodiment, the diffusion layer 361 may be formed of a transparent plastic such as polymethyl methacrylate (PMMA) or polycarbonate (PC).

In an embodiment, the adhesive layer 365 may protect the display panel 360 and may adhere the display panel 360 to a portion of components of the cover layer 370, for example, to the window layer 371 or the TSP 372. The adhesive layer 365 may be formed of an optical clear adhesive (OCA), an optical adhesive film, or an optical clear resin (OCR).

In an embodiment, the cover layer 370 may be coupled to the screen display direction of the display panel 360, for example, to an upper side (e.g., +Z direction) of the display panel 360. The cover layer 370 may include a protruding area 377 that protrudes beyond a side surface (e.g., a surface in an X-Y direction) of the display panel 360.

In an embodiment, the cover layer 370 may include a window layer 371 disposed so as to be exposed to an outside of the display device 301. Additionally, the cover layer 370 according to an embodiment may further include the TSP 372 disposed between the window layer 371 and the display panel 360.

In an embodiment, the window layer 371 may be formed of an insulating material such as glass, plastic, or crystal, or may be a transparent film. For example, the window layer 371 may be glass-based such as a thin glass (e.g., ultra-thin glass (UTG)) or plastic film-based such as a polyimide film.

In an embodiment, the TSP 372 may be a touch circuit (e.g., the touch circuitry 250 of FIG. 2) and may include a touch sensor or a pressure sensor. The TSP 372 may be a part of an input module (e.g., the input module 150 of FIG. 1) of the display device 301. The TSP 372 may receive an input from the outside (e.g., a user) of the display device 301 and transmit a signal to an internal component (e.g., the processor 120 of FIG. 1) of the display device 301.

In an embodiment, the TSP 372 may be coupled to a lower side (e.g., in a -Z direction) of the window layer 371. The TSP 372 may be formed in a roughly square flat shape having a size corresponding to the window layer 371.

In an embodiment, the TSP 372 is merely an configuration to describe the display device 301 having a touch function, and the TSP 372 may be omitted. For example, although the drawing shows that the inner mold 380 is coupled to the lower side of the TSP 372, in an embodiment of the display device 301 in which the TSP 372 is omitted, the inner mold 380 may be coupled to the window layer 371 or the light blocking member 375 of the cover layer 370.

In an embodiment, the light blocking member 375 may block light emitted in a front direction (e.g., +Z direction) in which the screen of the display device 301 is displayed from an outer side direction (e.g., X-Y plane direction). The light blocking member 375 may be disposed in the protruding area 377 of the cover layer 370 or in an area including the protruding area 377.

In an embodiment, the light blocking member 375 may be a black matrix (BM) and may be implemented in a black color. For example, the light blocking member 375 may include an opaque inorganic insulating material such as CrOx, MoOx, or carbon black, or an opaque organic insulating material such as a black resin.

In an embodiment, the sealing member 390 may be provided between the side surface of the display panel 360 and a bottom surface of the cover layer 370. The sealing member 390 may provide a fixing force (or lamination peeling force) between each component of the display module 350.

In an embodiment, the sealing member 390 may be filled to surround the side surface of the display panel 360 to seal joint portions of the lateral side ends of the display panel 360, the diffusion layer 361, the adhesive layer 365, and the cover layer 370.

For example, when pressure or impact is applied from the outside to the display device 301, a side surface of the display module 350 or a partial area adjacent thereto may be separated or detached. The sealing member 390 may be filled into the side surface of the display module 350 to provide a fixing force between the plurality of layers, and the sealing member 390 may also prevent or reduce separation or detachment of the partial area of the display module 350.

In an embodiment, the sealing member 390 may be made of a siliconebased or acrylic-based adhesive material. For example, the sealing member 390 may be activated at room temperature, or while heated, or may be activated by UV.

In an embodiment, the sealing member 390 may be made of a material having elongation at break. The elongation at break of the sealing member 390 may be a predetermined numerical value, or a range of numerical values, for example between 400% and 900%.

In an embodiment, a bezel 319 may be an area from a lateral end (or a lateral end of the cover layer 370) of the display module 350 to a lateral end of the housing 310. The bezel 319 may be an area surrounding a screen display area of the display device 301. The bezel 319 may be an area where the screen is not displayed or the screen is occluded.

In an embodiment, as the bezel 319 becomes thinner, the screen display area of the display device 301 may become relatively wider, or a user's gaze of the display device 301 may be reduced from being distracted and the degree of immersion may be increased.

In an embodiment, the inner mold 380 may be coupled to a lower side of the protruding area 377 of the cover layer 370. The inner mold 380 may be disposed at a predetermined distance from the side surface of the display panel 360.

In an embodiment, the inner mold 380 may include a guide area 389. The guide area 389 may be an area that protrudes from an upper side (e.g., a +Z direction) surface of the inner mold 380 and faces a side surface of the cover layer 370.

In an embodiment, based on the display module 350 in a state in which the display panel 360 and the cover layer 370 are coupled by the adhesive layer 365 and the sealing member 390, the guide area 389 may guide a position at which the display module 350 is coupled to the housing 310. Alternatively, the guide area 389 may guide the cover layer 370 so that the cover layer 370 is not disposed in close contact with the housing 310, and may prevent or reduce contact or collision between the display module 350 and the housing 310.

In an embodiment, a first adhesive member 393 may bond the inner mold 380 and the housing 310. A second adhesive member 395 may bond the inner mold 380 and the cover layer 370. The first adhesive member 393 and the second adhesive member 395 may be made of different materials or have different compositions.

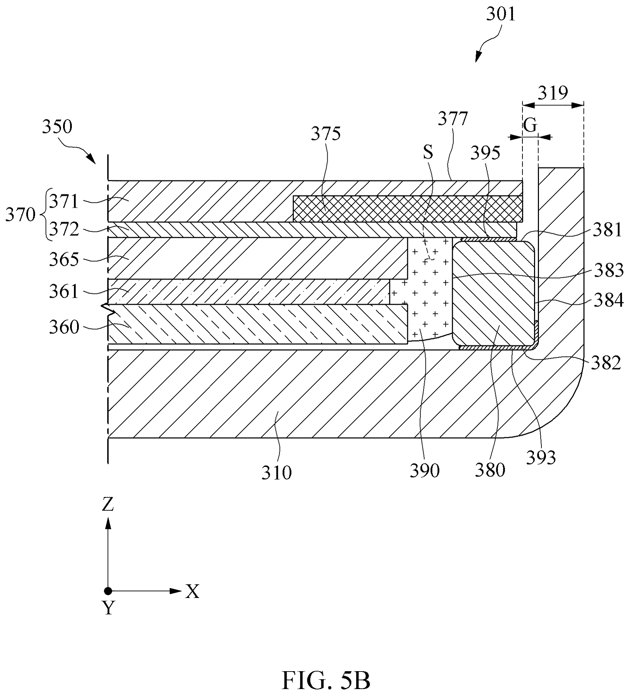

FIG. 5B is a schematic view illustrating a cross-section of the display device according to an embodiment of the disclosure.

Referring to FIG. 5B, the inner mold 380 according to an embodiment may be disposed on a lower side of the cover layer 370.

Hereinafter, the description provided above is not repeated, and it is obvious that a portion of the configuration and structure of the display device 301 may be replaced, added, or omitted within a scope easily understandable by one of ordinary skill in the art with reference to the following drawings and descriptions. In addition, at least one component or feature of the embodiments described above may be coupled to the display device 301 unless this is technically and clearly infeasible.

In an embodiment, the inner mold 380 may include a first surface 381, a second surface 382, a third surface 383, and a fourth surface 384. The first surface 381, the second surface 382, the third surface 383, and the fourth surface 384 may be defined as a plurality of surfaces based on a direction in which the inner mold 380 is facing. Without being limited thereto, the plurality of surfaces 381, 382, 383, and 384 of the inner mold 380 may be variously defined based on a direction in which each surface faces within a range understandable by one of ordinary skill in the art.

In an embodiment, the definitions of the plurality of surfaces 381, 382, 383, and 384 may vary, for example, at least a portion of the plurality of surfaces 381, 382, 383, and 384 may be integrated into one, at least a portion of the plurality of surfaces 381, 382, 383, and 384 may be continuous, or at least a portion of the plurality of surfaces 381, 382, 383, and 384 may have a curved structure. Alternatively, boundaries of the plurality of surfaces 381, 382, 383, and 384 may be interpreted in various ways depending on the reference.

In an embodiment, the first surface 381 may be a surface facing the protruding area 377 of the cover layer 370. In an embodiment, the second surface 382 may be opposite the first surface 381 and may be a surface facing the housing 310. In an embodiment, the third surface 383 may extend from the first surface 381 to the second surface 382 and may be a surface facing the sealing member 390. In an embodiment, the fourth surface 384 may extend from the first surface 381 to the second surface 382 and may be a surface opposite the third surface 383.

In an embodiment, based on the cross-section of FIG. 5B, the first surface 381 according to an embodiment may be a top surface (e.g., a surface in a +Z direction). In an embodiment, the second surface 382 may be a bottom surface (e.g., a surface in a -Z direction). In an embodiment, the third surface 383 may be a side surface (e.g., a surface in a -X direction) facing the display panel 360. In an embodiment, the fourth surface 384 may be a side surface (e.g., a surface in a +X direction) facing the housing 310.

In an embodiment, the inner mold 380 may be disposed on the lower side of the cover layer 370. Compared to FIG. 5A, the inner mold 380 according to an embodiment may omit the guide area 389, and the inner mold 380 may be disposed under the cover layer 370. By omitting the guide area 389 of the inner mold 380, the display device 301 may reduce the width of the bezel 319.

In an embodiment, the inner mold 380 may be disposed a predetermined distance apart from the side surface of the display panel 360. For example, the predetermined distance may be, but is not limited to, a distance between 0.05 mm and 0.3 mm, or a distance between 0.15 mm and 0.25 mm.

In an embodiment, a spacing S may be formed between the inner mold 380 and the display panel 360. The spacing S may be provided between the side surface of the display panel 360, the bottom surface of the cover layer 370, and the third surface 383 of the inner mold 380.

In an embodiment, the sealing member 390 may be provided in the spacing S. The sealing member 390 may contact each of the display panel 360, the cover layer 370, and the inner mold 380 in the spacing S. The sealing member 390 disposed in the spacing S and in contact with a plurality of structures may provide improved fixing force.

In an embodiment, the sealing member 390 may additionally contact the inner mold 380, thereby improving the structural stability of the display device 301. In addition, since the sealing member 390 is arranged in a manner to fill the spacing S, a relatively larger amount may be filled and the fixing force may be increased. For example, compared to FIG. 5A, the amount of the sealing member 390 of FIG. 5B may be 1.5 to 1.7 times more.

In an embodiment, referring to FIG. 5A, after the sealing member 390 is applied to the display module 350, the display module 350 may be coupled to the inner module. Since the sealing member 390 may invade the space where the inner mold 380 is disposed, the amount of the sealing member 390 filled may be limited. Additionally, the width of the bezel 319 of the display device 301 may increase.

In an embodiment, referring to FIG. 5B, after the spacing S is formed by coupling the inner mold 380 to the cover layer 370, the sealing member 390 may be filled into the spacing S. Since the sealing member 390 is filled in a previously formed spacing S, a relatively larger amount of the sealing member 390 may be stably filled. Additionally, the width of the bezel 319 of the display device 301 may be reduced.

In an embodiment, the inner mold 380 may have a columnar cross-section extending from the first surface 381 toward the second surface 382. The inner mold 380 having the columnar cross-section may expand a vertical width (e.g., a length in a -Z axis direction) of the spacing S. The inner mold 380 in the shape of the column may increase the volume of the spacing S, guide a position where the sealing member 390 is filled, and/or increase the amount of the sealing member 390 to be filled.

In an embodiment, the second surface 382 of the inner mold 380 may be disposed to protrude beyond the bottom surface of the display panel 360. The display panel 360 may be indirectly connected to the inner mold 380 through the cover layer 370 and the sealing member 390.

In an embodiment, the inner mold 380 may be disposed so as to protrude beyond the display panel 360, so that the display panel 360 may be disposed at a predetermined distance from the housing 310. When the display panel 360 and the housing 310 come into contact, the display panel 360 may be damaged by external impact, so the inner mold 380 according to an embodiment may stably protect the display panel 360 by spacing the display panel 360 from the housing 310.

In an embodiment, the first adhesive member 393 may be applied between the first surface 381 of the inner mold 380 and the bottom surface of the cover layer 370. The second adhesive member 395 may be applied between at least one of the second surface 382 and the fourth surface 384 of the inner mold 380 and the housing 310.

In an embodiment, when the inner mold 380 is disposed on the lower side of the cover layer 370, an area over which the second adhesive member 395 is applied may be relatively increased, and a bonding strength of the second adhesive member 395 may be improved.

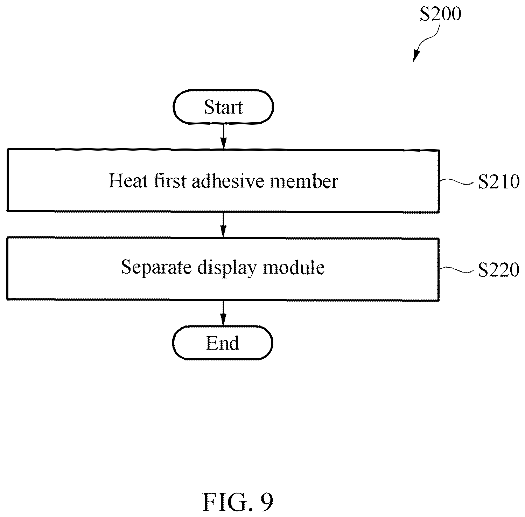

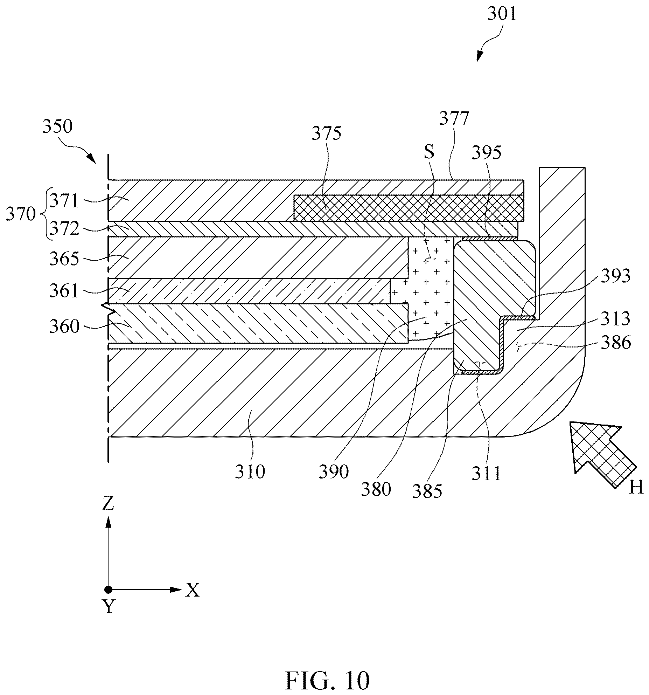

In an embodiment, the first adhesive member 393 may be made of a thermoplastic material. The first adhesive member 393 may be deformed or adhesion may be reduced when heat is applied. When separation of the display module 350 and the housing 310 is required, the user may heat the first adhesive member 393 to separate the display module 350 and the housing 310 (e.g., refer to a disassembling method S200 of FIGS. 9 and 10).

In an embodiment, the second adhesive member 395 may be made of a different material from the first adhesive member 393. Since only one of the first adhesive member 393 and the second adhesive member 395 may need to be separated depending on the need, the materials of the first adhesive member 393 and the second adhesive member 395 may be configured differently, so that the user may selectively separate only one depending on heating conditions (e.g., temperature, time, or heating manner).

In an embodiment, the inner mold 380 may be disposed to protrude a predetermined distance from a side surface (e.g., a surface in a +X direction) of the cover layer 370. The inner mold 380 may guide the cover layer 370 and the housing 310 so as not to come into close contact with each other and are spaced apart from each other by a predetermined distance.

In an embodiment, the housing 310 may be spaced apart from a side surface of the cover layer 370 by a predetermined distance, and a gap G may be formed between the housing 310 and the cover layer 370. The gap G may provide an attachment tolerance between the housing 310 and the display module 350. Additionally, the gap G may prevent or reduce collision between the housing 310 and the display module 350.

For example, in a process of assembling the display module 350 into the housing 310, there may be a predetermined difference in an area of the display module 350 and an area of the housing 310. For example, a gap G of between 0.05 mm and 0.3 mm may be formed from an edge of the cover layer 370 to the housing 310. Since the inner mold 380 is disposed to protrude beyond the side surface of the cover layer 370, the display device 301 may stably form the gap G before assembling the housing 310.

In an embodiment, the gap G may prevent or reduce damage of the display module 350. For example, when the cover layer 370 and the housing 310 are in close contact, the display module 350 may be damaged by impact with the housing 310. As the inner mold 380 is disposed to protrude, the inner mold 380 may prevent or reduce collision of the display module 350.

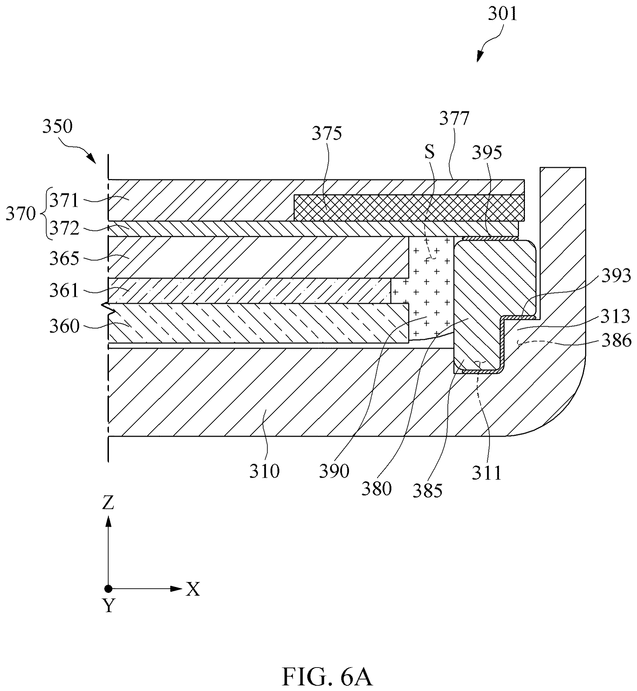

FIG. 6A is a schematic view illustrating a cross-section of the display device according to an embodiment of the disclosure.

Referring to FIG. 6A, the display device 301 according to an embodiment may include at least one of a first groove 311, a first insertion area 385, a second groove 386, and a second insertion area 313.

Hereinafter, the description provided above is not repeated, and it is obvious that a portion of the configuration and structure of the display device 301 may be replaced, added, or omitted within a scope easily understandable by one of ordinary skill in the art with reference to the following drawings and descriptions. In addition, at least one component or feature of the embodiments described above may be coupled to the display device 301 unless this is technically and clearly infeasible.

In an embodiment, the first groove 311 may be provided on the inside of the housing 310. The first groove 311 may be an area that is concave downward on an inner side surface of the housing 310.

In an embodiment, the first insertion area 385 may be provided in the inner mold 380. The first insertion area 385 may be an area that protrudes downward (e.g., in a -Z direction) from the inner mold 380.

In an embodiment, the first insertion area 385 may be inserted into the first groove 311. The first insertion area 385 may be fitted into the first groove 311, and the inner mold 380 and the housing 310 may be combined. The first groove 311 and the first insertion area 385 may improve a coupling strength of the inner mold 380 and the housing 310.

In an embodiment, the first groove 311 and the first insertion area 385 may guide a coupling position of the housing 310 and the inner mold 380, thereby improving ease of assembly. Alternatively, the first groove 311 and the first insertion area 385 may increase an area on which the first adhesive member 393 is applied, thereby improving the adhesion.

In an embodiment, the display device 301 may further include the second groove 386 and the second insertion area 313. Alternatively, the display device 301 may include the second groove 386 and the second insertion area 313, excluding the first groove 311 and the first insertion area 385.

In an embodiment, the second groove 386 may be provided on a surface of the inner mold 380 facing the housing 310. The second groove 386 may be a concave area on the inside of the inner mold 380.

In an embodiment, the second insertion area 313 may be an area that protrudes upward (e.g., in a +Z direction) from the housing 310. The second insertion area 313 may be provided in the housing 310.

In an embodiment, the second insertion area 313 may be inserted into the second groove 386. The second insertion area 313 may be fitted into the second groove 386, and the inner mold 380 and the housing 310 may be combined. The second groove 386 and the second insertion area 313 may improve the coupling strength of the inner mold 380 and the housing 310.

In an embodiment, the second groove 386 and the second insertion area 313 may guide the coupling position of the housing 310 and the inner mold 380, thereby improving ease of assembly. Alternatively, the second groove 386 and the second insertion area 313 may increase the area on which the first adhesive material 393 is applied, thereby improving the adhesion.

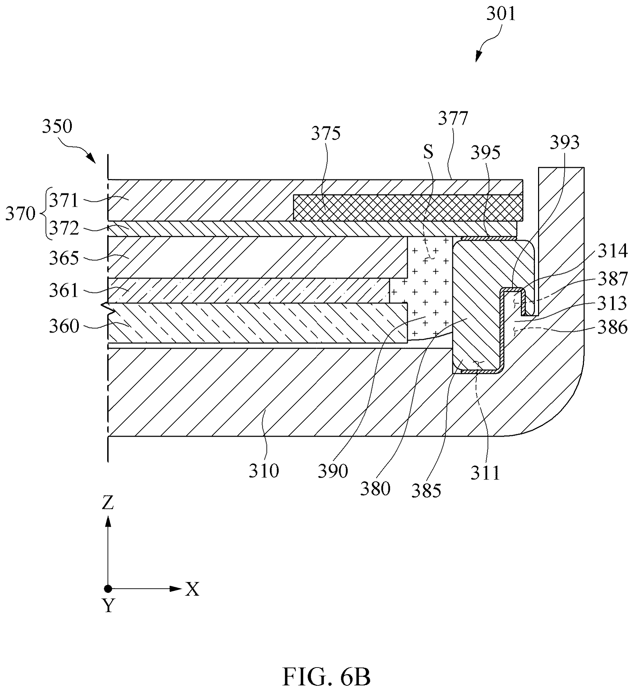

FIG. 6B is a schematic view illustrating a cross-section of the display device according to an embodiment of the disclosure.

Referring to FIG. 6B, the display device 301 according to an embodiment may further include a third groove 387 and a third insertion area 314.

Hereinafter, the description provided above is not repeated, and it is obvious that a portion of the configuration and structure of the display device 301 may be replaced, added, or omitted within a scope easily understandable by one of ordinary skill in the art with reference to the following drawings and descriptions. In addition, at least one component or feature of the embodiments described above may be coupled to the display device 301 unless this is technically and clearly infeasible.

In an embodiment, the third groove 387 may be provided on the second groove 386 in the inner mold 380. The third groove 387 may be an area that is more concave inwardly than the second groove 386.

In an embodiment, the third insertion area 314 may be provided on the second insertion area 313 in the housing 310. The third insertion area 314 may be an area that protrudes further upward (e.g., in the +Z direction) from the second insertion area 313.

In an embodiment, the third insertion area 314 may be inserted into the third groove 387. The third insertion area 314 may be fitted into the third groove 387, and the inner mold 380 and the housing 310 may be combined. The third groove 387 and the third insertion area 314 may improve the coupling strength of the inner mold 380 and the housing 310.

In an embodiment, the third groove 387 and the third insertion area 314 may guide the coupling position of the housing 310 and the inner mold 380, thereby improving ease of assembly. Alternatively, the third groove 387 and the third insertion area 314 may increase the area on which the first adhesive member 393 is applied, thereby improving the adhesion.

In an embodiment, the display device 301 may include the first groove 311, the first insertion area 385, the second groove 386, the second insertion area 313, and may further include the third groove 387 and the third insertion area 314. Alternatively, the display device 301 may include the second groove 386, the second insertion area 313, the third groove 387, and the third insertion area 314, excluding the first groove 311 and the first insertion area 385.

Without being limited thereto, the housing 310 and the inner mold 380 may include a combined structure of various shapes and structures. For example, contact surfaces of the housing 310 and the inner mold 380 may have a cross-section that is curved or bent in at least a partial area, and the contact surfaces of the housing 310 and the inner mold 380 may have a shape that faces each other and interlocks.

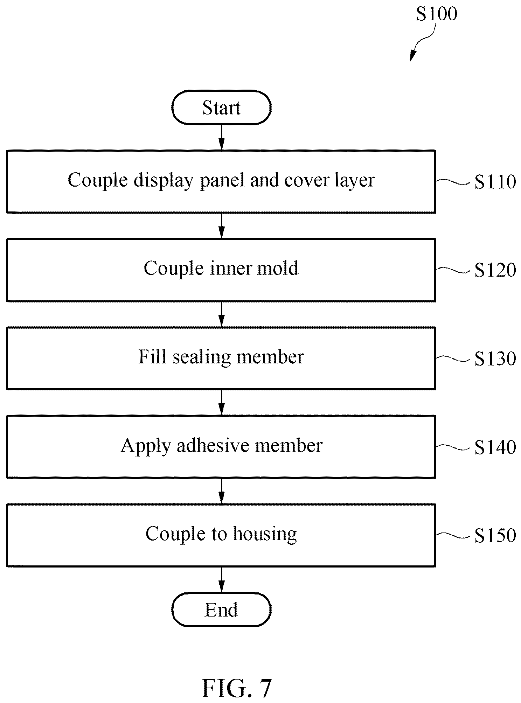

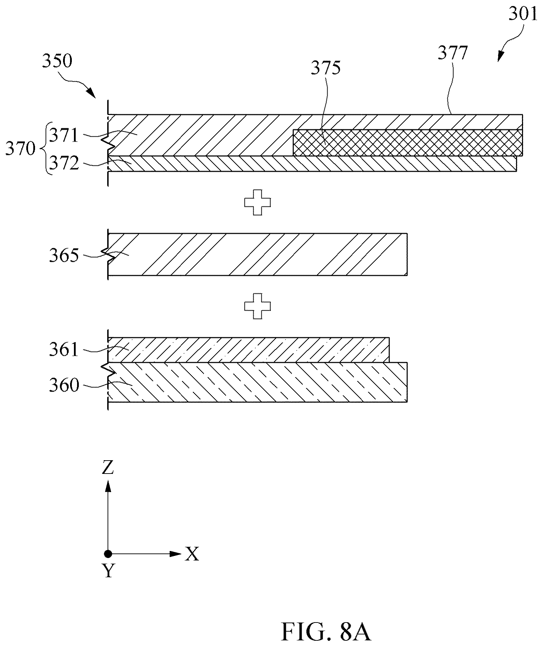

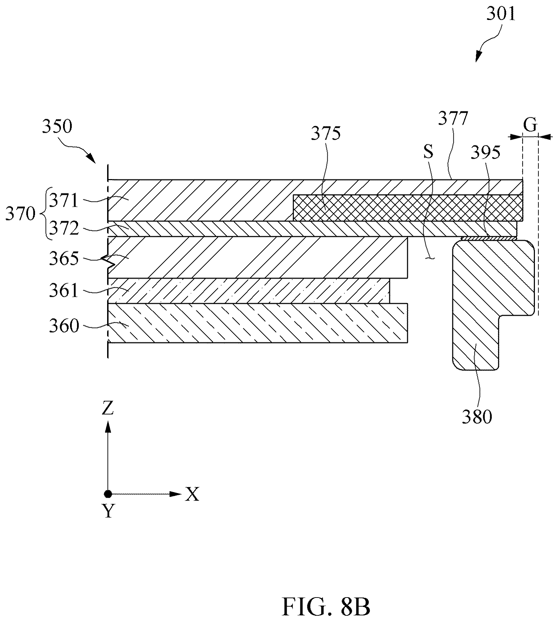

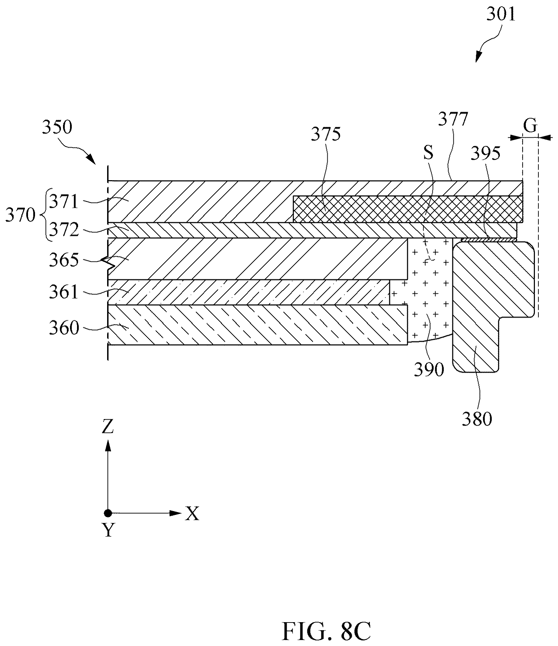

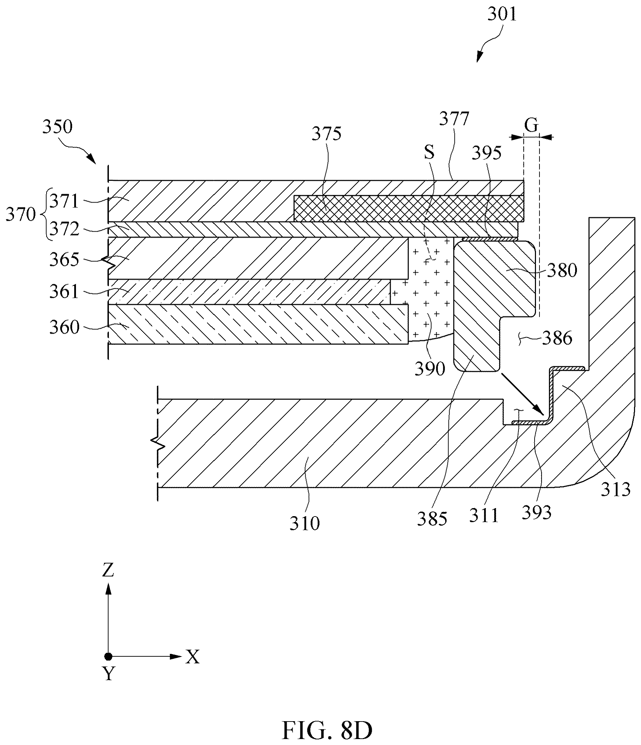

FIG. 7 is a flowchart of a manufacturing method of the display device according to an embodiment of the disclosure. And FIGS. 8A, 8B, 8C, and 8D are schematic views each illustrating a cross-section of a state of the manufacturing method S100 of the display device 301 according to various embodiments of the disclosure.

Referring to FIG. 7, the manufacturing method S100 of the display device 301 according to an embodiment may include at least one of coupling, at operation S110, the display panel 360 and the cover layer 370, coupling, at operation S120, the inner mold 380, filling, at operation S130, the sealing member 390, applying, at operation S140, an adhesive member, and coupling, at operation S150, to the housing 310.

Hereinafter, the description provided above is not repeated, and the display device 301 that is the target of the manufacturing method S100 is not limited to the display device 301 of the above-described drawings and descriptions. In addition, in the display device 301 and the manufacturing method S100, it is obvious that a portion of the configurations and structures may be replaced, added, or omitted within a scope easily understandable by one of ordinary skill in the art with reference to the following drawings and descriptions. In addition, at least one component or feature of the embodiments described above may be coupled to the display device 301 or added to the manufacturing method S100 unless this is technically and clearly infeasible.

Referring to FIG. 8A, in an embodiment, the coupling at operation S110 of the display panel 360 and the cover layer 370 may include coupling the cover layer 370 including the protruding area 377 that protrudes beyond the side surface of the display panel 360 to the upper side (e.g., in the +Z direction) of the display panel 360. The diffusion layer 361 may be laminated on the upper side of the display panel 360, and the cover layer 370 may include the window layer 371 and the TSP 372. The adhesive layer 365 may be provided between the cover layer 370 and the display panel 360, specifically between the TSP 372 and the diffusion layer 361, to bond the display panel 360 and the window layer 371.

Referring to FIG. 8B, in an embodiment, the coupling at operation S120 of the inner mold 380 may include coupling the inner mold 380 to a lower side of the protruding area 377 so as to be spaced a predetermined distance from the side surface of the display panel 360. As the inner mold 380 is coupled, a spacing S may be formed between the display panel 360, the cover layer 370, and the inner mold 380.

In an embodiment, the coupling at operation S120 of the inner mold 380 may include coupling the inner mold 380 to the protruding area 377 such that the inner mold 380 protrudes a predetermined distance from a side surface of the cover layer 370. A gap G may be formed by the inner mold 380 protruding from the side surface of the cover layer 370. Since the inner mold 380 is disposed to protrude, the display device 301 may stably form the gap G before the housing 310 is assembled.

In an embodiment, since the gap G is formed in advance in the operation of coupling at operation S120 the inner mold 380, the coupling S140 of the inner mold 380 to the housing 310, which will be described later, may include placing the housing 310 at a predetermined distance from the side surface of the cover layer 370 so that the gap G is formed between the housing 310 and the cover layer 370.

In an embodiment, the gap G may provide an attachment tolerance between the housing 310 and the display module 350. Additionally, the gap G may prevent or reduce collision between the housing 310 and the display module 350.

For example, in a process of assembling the display module 350 into the housing 310, there may be a predetermined difference in an area of the display module 350 and an area of the housing 310. For example, a gap G of between 0.05 mm and 0.3 mm may be formed from an edge of the cover layer 370 to the housing 310. Since the inner mold 380 is disposed to protrude beyond the side surface of the cover layer 370, the display device 301 may stably form the gap G before assembling the housing 310.

In an embodiment, the gap G may prevent or reduce damage of the display module 350. For example, when the cover layer 370 and the housing 310 are in close contact, the display module 350 may be damaged by impact with the housing 310. As the inner mold 380 is disposed to protrude, the inner mold 380 may prevent or reduce collision of the display module 350.

In an embodiment, the coupling at operation S120 of the inner mold 380 may include applying the second adhesive member 395 having a different material or composition from the first adhesive member 393 to an area where the protruding area 377 and the inner mold 380 come into contact, and coupling the protruding area 377 and the inner mold 380. Without being limited thereto, the first adhesive member 393 and the second adhesive member 395 may have the same or similar materials and compositions.

Referring to FIG. 8C, in an embodiment, the filling at operation S130 of the sealing member 390 may include filling the sealing member 390 in a spacing S between the inner mold 380 and the display panel 360. The spacing S may provide sufficient space for the sealing member 390 to be filled.

In an embodiment, the filling at operation S130 of the sealing member 390 may include filling the sealing member 390 such that the sealing member 390 contacts each of the display panel 360, the cover layer 370, and the inner mold 380. The sealing member 390 may provide improved fixing force by being filled in a previously formed spacing S and thereby contacting each of the display panel 360, the cover layer 370, and the inner mold 380.

The manufacturing method S100 according to an embodiment of the disclosure may form in advance a spacing S to be filled with the sealing member 390 by first bonding the inner molding to the display panel 360 and the cover layer 370 before bonding the inner molding to the housing 310.

In an embodiment, since the spacing S is formed in advance before filling the sealing member 390, the amount of the sealing member 390 to be filled may increase, the sealing member 390 may be stably filled, and/or the fixing force of the sealing member 390 may be improved.

For example, since the sealing member 390 is arranged in a manner to fill the spacing S, a relatively larger amount may be filled and the fixing force may be increased. For example, compared to an example where the sealing member 390 is first applied to the display panel 360 and the cover layer 370 and then the inner mold 380 is coupled, the manufacturing method S100 according to an embodiment of the disclosure may have an amount of the sealing member 390 that is 1.5 to 1.7 times more.

According to an embodiment of the disclosure, the manufacturing method S100 may stably fill a relatively larger amount of the sealing member 390 by filling the sealing member 390 in a previously formed spacing S, and may reduce the width of a bezel (e.g., the bezel 319 of FIG. 5A or 5B) of the manufactured display device 301.

The manufacturing method S100 according to an embodiment of the disclosure may relatively easily place an appropriate amount of the sealing member 390 by filling the sealing member 390 into the spacing S, thereby increasing the efficiency of a working process of the sealing member 390.

The manufacturing method S100 according to an embodiment of the disclosure may improve the fixing force between components of the display device 301 and reduce the width of the bezel 319, thereby improving the quality of the display device 301 and increasing the manufacturing yield.

Referring to FIG. 8D, in an embodiment, the coupling at operation S150 to the housing 310 may include coupling the inner mold 380 to the housing 310 such that the display panel 360 is disposed inside the housing 310. The coupling at operation at operation S150 to the housing 310 may be performed by applying the first adhesive member 393 made of a thermoplastic material to an area where the housing 310 and the inner mold 380 come into contact, and coupling the housing 310 and the inner mold 380.

In an embodiment, the coupling at operation S150 to the housing 310 may include inserting the first insertion area 385 of the inner mold 380 into the first groove 311 provided on the inside of the housing 310. And/or, the coupling at operation S150 to the housing 310 may include inserting the second insertion area 313 of the housing 310 into the second groove 386 provided in the inner mold 380.

In an embodiment, each of the first groove 311, the first insertion area 385, the second groove 386, and the second insertion area 313 may guide the coupling position of the housing 310 and the inner mold 380, thereby improving ease of assembly. Alternatively, each of the first groove 311, the first insertion area 385, the second groove 386, and the second insertion area 313 may increase the area on which the first adhesive member 393 is applied, thereby improving the adhesion of the first adhesive member 393.

FIG. 9 is a flowchart of a disassembling method of the display device 301 according to an embodiment of the disclosure. and FIG. 10 is a schematic view illustrating a cross-section of a state of the disassembling method of the display device according to an embodiment of the disclosure.

Referring to FIG. 9, the disassembling method S200 of the display device 301 according to an embodiment may include at least one of heating at operation S210 an adhesive member and separating at operation S220 the display module 350.

Hereinafter, the description provided above is not repeated, and the display device 301 that is the target of the disassembling method S200 is not limited to the display device 301 of the above-described drawings and descriptions. In addition, in the display device 301 and the disassembling method S200, it is obvious that a portion of the configurations and structures may be replaced, added, or omitted within a scope easily understandable by one of ordinary skill in the art with reference to the following drawings and descriptions. In addition, at least one component or feature of the embodiments described above may be coupled to the display device 301 or added to the disassembling method S200 unless this is technically and clearly infeasible.

In an embodiment, the display module 350 may include the display panel 360, the cover layer 370, the inner mold 380, and the sealing member 390. For example, the cover layer 370 may be coupled to an upper side of the display panel 360 and may include the protruding area 377 that protrudes beyond a side surface of the display panel 360. The inner mold 380 may be disposed on a lower side of the protruding area 377 of the cover layer 370 so as to be spaced a predetermined distance from the side surface of the display panel 360.

In an embodiment, the sealing member 390 may be provided in a spacing S between the inner mold 380 and the display panel 360, and may contact each of the display panel 360, the cover layer 370, and the inner mold 380. However, this is merely an description, and the configuration, arrangement, and structure of the display device 301 and the display module 350 are not limited to the drawings and descriptions provided herein.

Referring to FIG. 10, in an embodiment, the heating at operation S210 of the adhesive member (e.g., the first adhesive member 393) may include heating the first adhesive member 393 made of a thermoplastic material and provided between the inner mold 380 and the housing 310. The heating at operation S210 of the adhesive member may also include heating an external area of the housing 310 opposite to a position where the inner mold 380 is disposed in a rear or lower side direction (e.g., -Z direction, or -Z and -X directions) of the housing 310 (refer to heating direction H of FIG. 10).

In an embodiment of the disclosure, the disassembling method S200 of the display device 301 may separate the display module 350 relatively easily and stably by applying heat from the rear side of the housing 310 opposite the area where the display module 350 is disposed, compared to a case where heat is applied in the direction of the display module 350.

In an embodiment, the separating at operation S220 of the display module 350 may include separating the display module 350 from the housing 310. For example, the separating at operation S220 of the display module 350 may include separating the first insertion area 385 of the inner mold 380 from the first groove 311 provided in the housing 310. And/or, the separating at operation S220 of the display module 350 may include separating the second insertion area 313 of the housing 310 from the second groove 386 provided in the inner mold 380.

The display device 301 according to an embodiment may include the housing 310, the display panel 360 provided inside the housing 310, the cover layer 370 coupled to an upper side of the display panel 360 and including the protruding area 377 that protrudes beyond a side surface of the display panel 360, the inner mold 380 disposed on a lower side of the protruding area 377 of the cover layer 370 so as to be spaced a predetermined distance from the side surface of the display panel 360, and the sealing member 390 provided in a spacing S between the inner mold 380 and the display panel 360. In an embodiment, the sealing member 390 may contact each of the display panel 360, the cover layer 370, and the inner mold 380.

In an embodiment, the housing 310 may include the first groove 311 provided on the inside. In an embodiment, the inner mold 380 may include the first insertion area 385 that is inserted into the first groove 311.

In an embodiment, the inner mold 380 may include the second groove 386 provided on a surface facing the housing 310. In an embodiment, the housing 310 may include the second insertion area 313 that is inserted into the second groove 386.

In an embodiment, the inner mold 380 may include the first surface 381 facing the protruding area 377 of the cover layer 370, the second surface 382 opposite the first surface 381 and facing the housing 310, the third surface 383 extending from the first surface 381 to the second surface 382 and facing the sealing member 390, and the fourth surface 384 extending from the first surface 381 to the second surface 382 and opposite the third surface 383.

In an embodiment, the inner mold 380 may have a columnar cross-section extending from the first surface 381 toward the second surface 382.

In an embodiment, the second surface 382 of the inner mold 380 may be disposed to protrude beyond the bottom surface of the display panel 360.

In an embodiment, the display device 301 may further include the first adhesive member 393 made of a thermoplastic material, which adheres the housing 310 to the inner mold 380.

In an embodiment, the display device 301 may further include the second adhesive member 395 that adheres the cover layer 370 to the inner mold 380 and is made of a different material from the first adhesive member 393.

In an embodiment, the inner mold 380 may be disposed so as to protrude a predetermined distance from the side surface of the cover layer 370.

In an embodiment, the housing 310 may be spaced a predetermined distance from the side surface of the cover layer 370 such that a gap G is formed between the housing 310 and the cover layer 370.

Alternatively, the manufacturing method S100 of the display device 301 according to an embodiment may include coupling at operation S110 the cover layer 370 including the protruding area 377 that protrudes beyond a side surface of the display panel 360 to an upper side of the display panel 360, coupling at operation S120 the inner mold 380 to a lower side of the protruding area 377 so as to be spaced a predetermined distance from the side surface of the display panel 360, filling at operation S130 the sealing member 390 into a spacing S between the inner mold 380 and the display panel 360, and coupling at operation S140 the inner mold 380 to the housing 310 such that the display panel 360 is placed inside the housing 310. In an embodiment, the filling at operation S130 of the sealing member 390 may include filling the sealing member 390 such that the sealing member 390 contacts each of the display panel 360, the cover layer 370, and the inner mold 380.

In an embodiment, the coupling at operation S140 of the inner mold 380 to the housing 310 may include inserting the first insertion area 385 of the inner mold 380 into the first groove 311 provided on the inside of the housing 310.

In an embodiment, the coupling at operation S140 of the inner mold 380 to the housing 310 may include inserting the second insertion area 313 of the housing 310 into the second groove 386 provided in the inner mold 380.

In an embodiment, the coupling at operation S120 of the inner mold 380 to the lower side of the protruding area 377 may include coupling the inner mold 380 to the protruding area 377 such that the inner mold 380 protrudes a predetermined distance from a side surface of the cover layer 370.

In an embodiment, the coupling at operation S140 of the inner mold 380 to the housing 310 may include placing the housing 310 at a predetermined distance from the side surface of the cover layer 370 so that the gap G is formed between the housing 310 and the cover layer 370.

In an embodiment, the coupling at operation S140 of the inner mold 380 to the housing 310 may be performed by applying the first adhesive member 393 made of a thermoplastic material to an area where the housing 310 and the inner mold 380 come into contact.

In an embodiment, the coupling S120 of the inner mold 380 to the lower side of the protruding area 377 may include applying the second adhesive member 395 having a different material from the first adhesive member 393 to an area where the protruding area 377 and the inner mold 380 come into contact.

Alternatively, in the disassembling method S200 of the display device 301 by separating the display module 350 from the housing 310 that accommodates the display module 350, the display module 350 may include the display panel 360, the cover layer 370 coupled to an upper side of the display panel 360 and including the protruding area 377 that protrudes beyond a side surface of the display panel 360, the inner mold 380 disposed on a lower side of the protruding area 377 of the cover layer 370 so as to be spaced a predetermined distance from the side surface of the display panel 360, and the sealing member 390 provided in a spacing S between the inner mold 380 and the display panel 360 and in contact with each of the display panel 360, the cover layer 370, and the inner mold 380. In an embodiment, the disassembling method S200 may include the heating at operation S210 of the first adhesive member 393 made of a thermoplastic material and provided between the inner mold 380 and the housing 310, and separating at operation S220 of the display module 350 from the housing 310. In an embodiment, the heating at operation S210 of the first adhesive member 393 may include heating an external area of the housing 310 opposite a position where the inner mold 380 is disposed in a lower direction of the housing 310.

In an embodiment, the separating at operation S220 of the display module 350 from the housing 310 may include separating the first insertion area 385 of the inner mold 380 from the first groove 311 provided in the housing 310.

In an embodiment, the separating at operation S220 of the display module 350 from the housing 310 may include separating the second insertion area 313 of the housing 310 from the second groove 386 provided in the inner mold 380.

While embodiments have been illustrated and described above, the present disclosure is not limited to the aforementioned specific embodiments. Those skilled in the art should appreciate that various modifications may be made to the embodiments without departing from the subject matter of the present disclosure as defined by the appended claims, and also that such modifications are not to be understood individually from the technical spirit or prospect of the present disclosure.

## Claims

1. A display device 301, comprising:
a housing 310;
a display panel 360 provided inside the housing 310;
a cover layer 370 coupled to an upper side of the display panel 360 and comprising a protruding area 377 that protrudes beyond a side surface of the display panel 360;
an inner mold 380 disposed on a lower side of the protruding area 377 of the cover layer 370 so as to be spaced a predetermined distance from the side surface of the display panel 360; and
a sealing member 390 provided in a spacing S between the inner mold 380 and the display panel 360,
wherein the sealing member 390 contacts each of the display panel 360, the cover layer 370, and the inner mold 380.

2. The display device 301 of claim 1, wherein
the housing 310 comprises a first groove 311 provided on the inside, and the inner mold 380 comprises a first insertion area 385 inserted into the first groove 311.

3. The display device 301 of claims 1 or 2, wherein
the inner mold 380 comprises a second groove 386 provided on a surface of the inner mold 380 facing the housing 310, and
the housing 310 comprises a second insertion area 313 inserted into the second groove 386.

4. The display device 301 of any one of claims 1 to 3, wherein the inner mold 380 comprises:
a first surface 381 facing the protruding area 377 of the cover layer 370;
a second surface 382 opposite the first surface 381 and facing the housing 310;
a third surface 383 extending from the first surface 381 to the second surface 382 and facing the sealing member 390; and
a fourth surface 384 extending from the first surface 381 to the second surface 382 and opposite the third surface 383.

5. The display device 301 of any one of claims 1 to 4, wherein the inner mold 380 is a columnar cross-section extending from the first surface 381 toward the second surface 382.

6. The display device 301 of any one of claims 1 to 5, wherein the second surface 382 of the inner mold 380 is disposed to protrude beyond a bottom surface of the display panel 360.

7. The display device 301 of any one of claims 1 to 6, wherein the display device 301 further comprises:
a first adhesive member 393 that adheres the housing 310 to the inner mold 380, and is made of a thermoplastic material.

8. The display device 301 of any one of claims 1 to 7, wherein the display device 301 further comprises:
a second adhesive member 395 that adheres the cover layer 370 to the inner mold 380, and is made of a different material from the first adhesive member 393.

9. The display device 301 of any one of claims 1 to 8, wherein the inner mold 380 is disposed to protrude a predetermined distance from a side surface of the cover layer 370.

10. The display device 301 of any one of claims 1 to 9, wherein the housing 310 is spaced a predetermined distance from the side surface of the cover layer 370 such that a gap G is formed between the housing 310 and the cover layer 370.

11. A manufacturing method S100 of a display device 301, comprising:
coupling S110, a cover layer 370 comprising a protruding area 377 that protrudes beyond a side surface of a display panel 360, to an upper side of the display panel 360;
coupling S120 an inner mold 380 to a lower side of the protruding area 377 so as to be spaced a predetermined distance from the side surface of the display panel 360;
filling S130 a sealing member 390 into a spacing S between the inner mold 380 and the display panel 360; and
coupling S140 the inner mold 380 to the housing 310 such that the display panel 360 is disposed inside the housing 310,
wherein the filling S130 of the sealing member 390 comprises
filling the sealing member 390 such that the sealing member 390 contacts each of the display panel 360, the cover layer 370, and the inner mold 380.

12. The manufacturing method S100 of claim 11, wherein the coupling S140 of the inner mold 380 to the housing 310 comprises
inserting a first insertion area 385 of the inner mold 380 into a first groove 311 provided on the inside of the housing 310.

13. The manufacturing method S100 of claims 11 or 12, wherein the coupling S140 of the inner mold 380 to the housing 310 comprises
inserting a second insertion area 313 of the housing 310 into a second groove 386 provided in the inner mold 380.

14. The manufacturing method S100 of any one of claims 11 to 13, wherein the coupling S120 of the inner mold 380 to the lower side of the protruding area 377 comprises
coupling the inner mold 380 to the protruding area 377 such that the inner mold 380 protrudes a predetermined distance from a side surface of the cover layer 370.

15. The manufacturing method S100 of any one of claims 11 to 14, wherein the coupling S140 of the inner mold 380 to the housing 310 comprises
placing the housing 310 at a predetermined distance spaced from the side surface of the cover layer 370 such that a gap G is formed between the housing 310 and the cover layer 370.
